# EUROPEAN PATENT SPECIFICATION

(11) **EP 3 951 837 B1**
(45) Date of publication and mention of the grant of the patent: **12.02.2025**
(21) Application number: 21768606.2
(22) Date of filing: 10.03.2021
(51) Int. Cl.: H01L 21/02, H01L 21/306

(54) **METHOD FOR PROCESSING SEMICONDUCTOR STRUCTURE**
VERFAHREN ZUR VERARBEITUNG EINER HALBLEITERSTRUKTUR
PROCÉDÉ DE TRAITEMENT D'UNE STRUCTURE SEMI-CONDUCTRICE

(30) Priority: 11.03.2020 CN 202010166572
(43) Date of publication of application: 09.02.2022
(73) Proprietor: Changxin Memory Technologies, Inc., Hefei, Anhui 230601 (CN)
(72) Inventor: LEE, Shin-hung, Hefei, Anhui 230601 (CN)
(74) Representative: Lavoix
(86) International application number: PCT/CN2021/079971
(87) International publication number: WO 2021/180121

(56) References cited:
- EP-A1- 1 132 951
- EP-A1- 2 490 249
- CN-A- 102 714 155
- CN-A- 102 741 984
- CN-A- 106 229 288
- CN-A- 107 068 538
- US-A1- 2005 022 839
- US-A1- 2010 122 711
- US-A1- 2011 189 858
- US-A1- 2016 086 845
- US-A1- 2016 172 433
- US-A1- 2016 172 433
- US-A1- 2017 186 620
- US-A1- 2018 076 022
- US-A1- 2019 189 455
- US-A1- 2019 267 232

## Description

### CROSS-REFERENCE TO RELATED APPLICATIONS

This application claims priority to Chinese Patent Application No. 202010166572.2, titled "METHOD FOR PROCESSING SEMICONDUCTOR STRUCTURE" and filed on March 11, 2020.

### TECHNICAL FIELD

The present disclosure relates to the field of semiconductor production technology, and more particularly, to a method for processing a semiconductor structure.

### BACKGROUND

With the rapid development of the semiconductor industry in recent years, high-aspect-ratio (HAR) nanostructures have been widely used in various fields. As nanometer devices are increasingly pursued in technology, the feature size of chips continues to shrink in a production process, and the entire semiconductor production technology is still developing towards further miniaturization of critical dimensions.

After patterns such as trenches are etched in semiconductor structures such as a Dynamic Random Access Memory (DRAM), steps of wet cleaning and drying are generally required to remove the byproduct generated in the etching process or the residual polymers generated after the etching process. However, in the processes of the wet cleaning and the drying, a capillary action may cause the collapse or deformation of the patterns. The smaller the sizes of the trenches formed by etching are, the greater the tension of the fluid likely appearing in the semiconductor structure is. There are three factors generally causing the collapse of the patterns: Laplace pressure; adhesive force; and electrostatic force, Van der Waals' force, and hydrogen-bond interaction. In an advanced DRAM production process, the collapse of the patterns may seriously affect the yield and productivity rate of the chips, and increasingly becomes a key factor in determining the success or failure of the DRAM production process. Particularly, a HAR Shallow Trench Isolation (STI) structure has more severe collapse or deformation of the patterns due to the capillary action in the wet cleaning. Therefore, it is of vital importance to eliminate or reduce the risk of the collapse of the pattern in the production of semiconductor devices such as the DARM.

However, in the more advanced DRAM production process, with the size of the structure becoming smaller and requirement for HAR, a great challenge is posed to the stability of the liquid environment during cleaning. Therefore, the surface effect of the cleaning liquid becomes a major factor affecting production quality. In some embodiments, the wet cleaning may cause the collapse of the patterns due to the capillary action on the pattern structures. The occurrence of the collapse of the patterns may be reduced by means of surface finishing of the HAR structure. However, this treatment method may lead to other negative effects, such as the super-hydrophobic effect of the HAR structure. This super-hydrophobic effect may prevent the aqueous solution from penetrating into the structure, resulting in a decrease in the effect of wet cleaning. In addition, taking the STI production as an example, a surface finishing agent is added after the wet cleaning before the drying process, which can effectively prevent the occurrence of pattern collapse. However, the surface finishing agent may remain at the bottom of the STI structure, which may cause abnormalities of the semiconductor devices.

D1 (US2016172433A1) discloses a surface treatment method for a semiconductor device having capacitor patterns, comprising: providing a substrate where a plurality of projected capacitor patterns are formed in a mold insulation layer; removing the mold insulation layer by using a wet etch solution; rinsing the substrate from which the mold insulation layer is removed with deionized water; treating the substrate with an SC-1 (NHOH+HO+OH) solution; rinsing the treated substrate with deionized water; forming a hydrophobic coating layer on a surface of each of plurality of the projected capacitor patterns; rinsing the substrate where the hydrophobic coating layer is formed with deionized water; and drying the substrate, wherein the hydrophobic coating layer is formed using a coating agent that includes phosphate having more than one hydrocarbon group, phosphonate having more than one hydrocarbon group, or a mixture thereof.

D2 (EP2490249A1) discloses a chemical solution for forming a water-repellent protective film on a wafer, which is a chemical solution containing a water-repellent-protective-film-forming agent for forming the water-repellent protective film, at the time of cleaning the wafer which has a finely uneven pattern at its surface and contains at least at a part of a surface of a recessed portion of the uneven pattern at least one kind of matter selected from the group consisting of titanium, titanium nitride, tungsten, aluminum, copper, tin, tantalum nitride, ruthenium and silicon, at least on the surface of the recessed portion, the chemical solution being characterized in that the water-repellent-protective-film-forming agent is a water-insoluble surfactant.

D3 (US2011189858A1) discloses a method of processing a wafer used in fabricating semiconductor devices, said method comprising: forming high aspect ratio features in a silicon based layer on the wafer; making sidewalls of the features more hydrophobic; performing wet processing of the wafer; and subsequently drying the wafer.

D4 (US2019189455A1) discloses a method for forming a semiconductor device, comprising: forming a silicon-hydrogen (Si-H) terminated surface on a silicon structure that includes patterned features by exposing the silicon structure to a hydrogen fluoride (HF) containing solution; removing the HF containing solution via a deionized (DI) water rinse; forming a solvent on the Si-H terminated surface on the silicon structure; and performing a surface modification via hydrosilylation by exposing the Si-H terminated surface to an alkene and/or an alkyne.

D5 (US2017186620A1) discloses a substrate processing method comprising: a liquid processing process of supplying a processing liquid to a substrate having a surface on which a pattern having a plurality of convex portions is formed; a drying process of removing the processing liquid existing on the surface of the substrate to dry the substrate; and a separating process of separating a sticking portion between adjacent ones of the convex portions after the drying process.

D6 (EP1132951A1) discloses an improved pre-gate cleaning technique that results in a smoother wafer surface.

D7 (US20160086845A1) discloses a method for processing an inner wall surface of a micro vacancy.

D8 (US20180076022A1) discloses a method of treating a semiconductor substrate.

D9 (CN106229288A) discloses a method for preparing active regions.

Therefore, it is a technical problem to be solved urgently at present how to reduce the occurrence of pattern collapse or deformation in the wet cleaning process of the semiconductor structures to improve the performance of the semiconductor structures and increase the yield of the semiconductor devices.

### SUMMARY

The present disclosure provides a method for processing a semiconductor structure. This method is used for solving the problem of pattern collapse or deformation prone to occur in a cleaning process of the semiconductor structure, to improve the performance of the semiconductor structure and increase the yield of the semiconductor devices.

To solve the above problem, the present disclosure provides a method for processing a semiconductor structure, and the invention is set out in the appended set of claims. By using the method for processing a semiconductor structure provided by the present disclosure, a transition layer configured to reduce the capillary force exerted by a fluid on the etched structures is formed on the inner walls of the etched structures such that the probability of collapse or deformation of the etched structures is reduced in the subsequent process of drying the etched structures. Furthermore, the transition layer covering the inner walls of the etched structures is removed after being dried, so the attraction force between the patterns of the etched structures is broken such that the etched structures deformed in the previous drying process is restored to its original state, thereby further reducing the probability of collapse or deformation of the etched structures, improving the performance of the semiconductor structure, and increasing the productivity and the yield of the semiconductor devices.

### BRIEF DESCRIPTION OF THE DRAWINGS

FIG. 1 is a flowchart of a method for processing a semiconductor structure according to embodiments of the present disclosure;
FIG. 2A-FIG. 2F are schematic diagrams showing major technologies during processing a semiconductor structure according to embodiments of the present disclosure;
FIG. 3A-FIG. 3E are schematic diagrams showing major technologies during processing another semiconductor structure according to embodiments of the present disclosure; and
FIG. 4A-FIG. 4H are schematic sectional views of a processing chamber during processing a semiconductor structure according to embodiments of the present disclosure.

### DETAILED DESCRIPTION

A specific embodiment of a method for processing a semiconductor structure provided by the present disclosure is described in detail below with reference to the accompanying drawings.

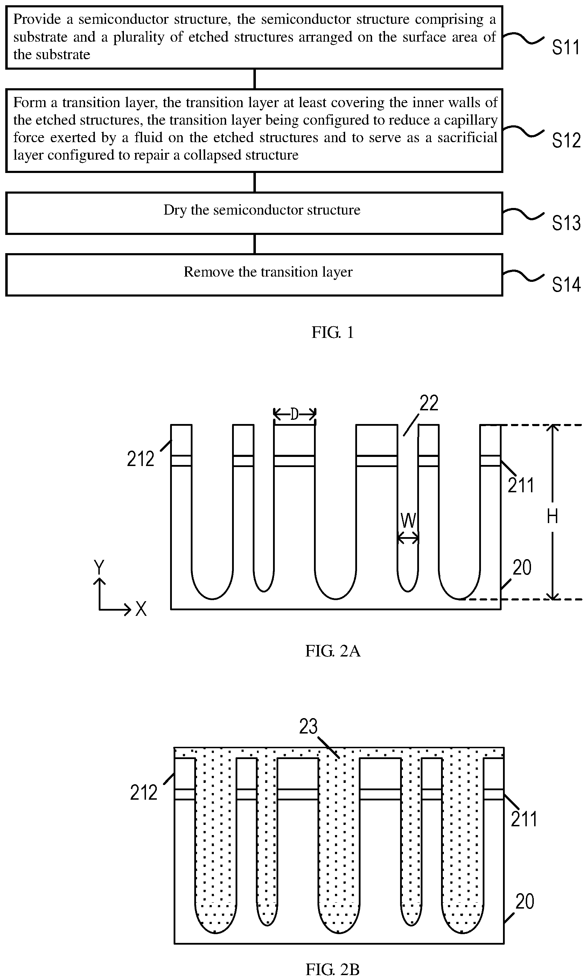

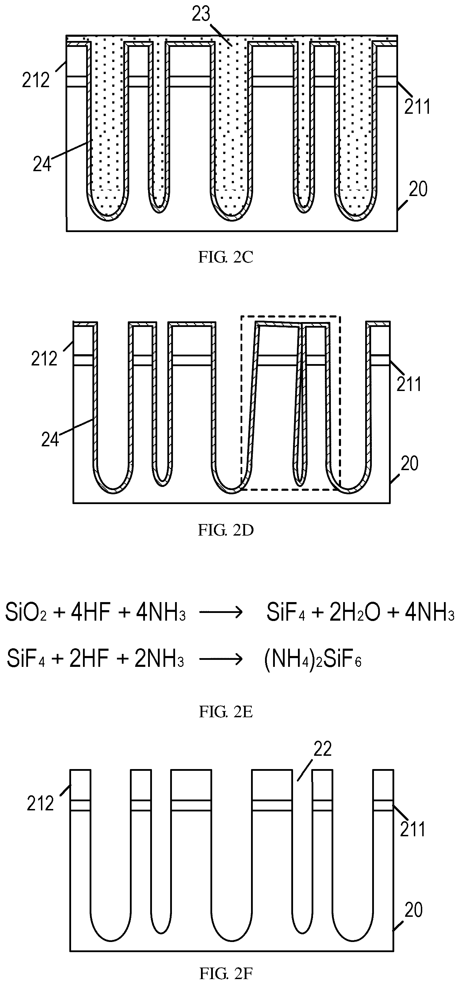

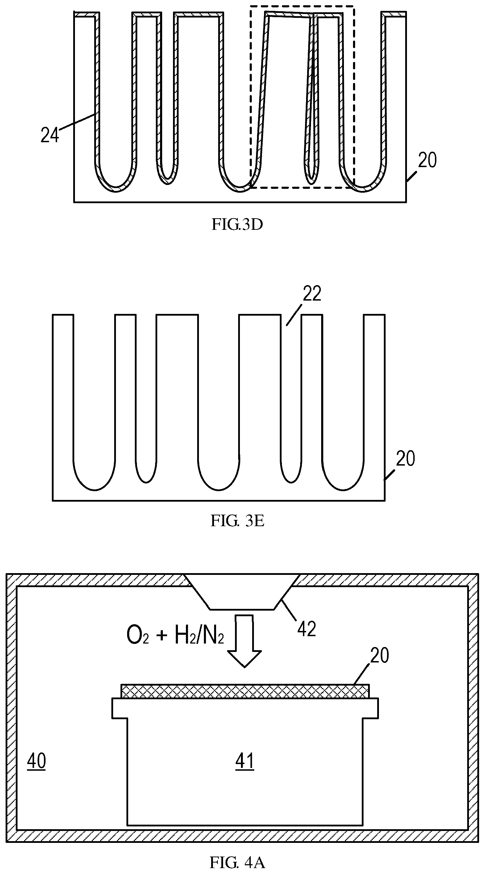

This specific embodiment provides a method for processing a semiconductor structure. FIG. 1 is a flowchart of the method for processing a semiconductor structure according to this specific embodiment of the present disclosure. FIG. 2A-FIG. 2F are schematic diagrams showing major technologies during processing a semiconductor structure according to this specific embodiment of the present disclosure. FIG. 4A-FIG. 4H are schematic sectional views of a processing chambers during processing a semiconductor structure according to this specific embodiment of the present disclosure. As shown in FIG. 1, -FIG. 2AFIG. 2F, and FIG. 4A-FIG. 4H, the method for processing a semiconductor structure provided by this specific embodiment includes following steps.

Step S11, providing a semiconductor structure, wherein the semiconductor structure comprises a substrate 20 and a plurality of etched structures 22 arranged on the surface area of the substrate 20, as shown in Fig. 2A.

In this specific embodiment, the etched structures 22 may be any structures formed on the substrate 20 by means of a dry etching process. In some embodiments, the etched structures are trenches, and the number of the trenches arranged on the surface area of the substrate is more than one.

The ratio of the depth H of the trench to the minimum width W of the trench is greater than 8.

In some embodiments, the trenches are arranged in parallel on the surface area of the substrate 20.

The width D of the pattern line between two adjacent trenches is less than 20nm.

In some embodiments, the etched structures 22 may be trenches such as shallow trench isolation (STI) extending from the surface of the substrate 20 into the substrate 20 along the direction (i.e., the Y-axis direction in FIG. 2A) perpendicular to the substrate 20. In semiconductor production processes, trenches with higher aspect ratio (HAR) are more likely to collapse or deform during the cleaning process. The method for processing a semiconductor structure provided in this embodiment is more effective in preventing the collapse or deformation of the trenches with higher aspect ratio during the cleaning process. FIG. 2A shows five trenches arranged in parallel on the surface area of the substrate 20 (i.e., the X-axis direction in FIG. 2A). In practical use, the specific number of the trenches may be determined by the person skilled in the art according to actual needs. The aspect ratios of the plurality of trenches may be same or different. The term "a plurality of" in this specific embodiment means two or more.

In some embodiments, the step of providing a semiconductor structure includes:
providing a substrate 20;
etching the substrate 20 to form the plurality of trenches on the surface area of the substrate 20, the bottoms of the trenches extending into the substrate 20 to form the semiconductor structure; and
cleaning the semiconductor structure to remove the impurities after forming the trenches by etching.

In some embodiments, cleaning the semiconductor structure comprises the following specific steps:
processing the semiconductor structure by means of a plasma ashing process to remove the polymer residues after forming the trenches by etching; and
processing the semiconductor structure by means of a wet cleaning process to remove the by-products and the pollutants generated after the etching process and the ashing process.

In some embodiments, processing the semiconductor structure by means of the plasma ashing process comprises the following specific steps:
performing the ashing process on the surface of the semiconductor structure by means of plasmonized oxygen to remove the polymer residues generated after the trenches are formed by the etching.

In some embodiments, performing the ashing process on the surface of the semiconductor structure by means of the plasmonized oxygen comprises the following specific step:
simultaneously introducing the plasmonized oxygen and a mixed gas composed of hydrogen and nitrogen, wherein the ratio of the flow of the oxygen to the flow of the mixed gas is 10:1. The volume ratio of the hydrogen in the mixed gas composed of the hydrogen and the nitrogen is 4%.

In some embodiments, the surface of the substrate 20 has a mask layer, such as a first mask layer 211 covering the surface of the substrate 20 and a second mask layer 212 covering the surface of the first mask layer 211 in FIG. 2A. The mask layer has a mask pattern. After the substrate 20 is etched by dry etching process or other etching processes along the mask pattern in the mask layer to form the trenches, some polymers (i.e., the polymer residues) may remain inside the trenches. Some by-products and pollutants may also be generated by the etching reaction between the etchant and the substrate 20. To avoid causing adverse effects on subsequent processes, in this specific embodiment, after etching the trenches, the polymer residues are first removed by the plasma ashing process, and then the by-products and the pollutants are removed by wet cleaning process, to make sure the inside of the trenches and the surface of the substrate clear. The material of the first mask layer 211 may be silicon oxide, and the material of the second mask layer 212 may be silicon nitride.

In the plasma ashing process, the flow rate of the oxygen is 5,000ml/min-30,000ml/min, the flow rate of the mixed gas composed of the hydrogen and the nitrogen (the volume ratio of the hydrogen is 4%) is 500ml/min~3,000ml/min, the temperature is 100°C~500°C, the duration is 10s~120s, the pressure in the processing chamber is of 200 mtorr~5,000 mtorr, and the radio frequency (RF) power is of 1,000 W~10,000 W. In wet cleaning process, the cleaning agent may be diluted HF (DHF), wherein the volume ratio of the HF (49% HF liquid) to the deionized water is 1: (1~1000), the duration is 5s~600s, the temperature is 15°C~60°C, and the rotation speed of the support platform is 100rpm~3,000rpm.

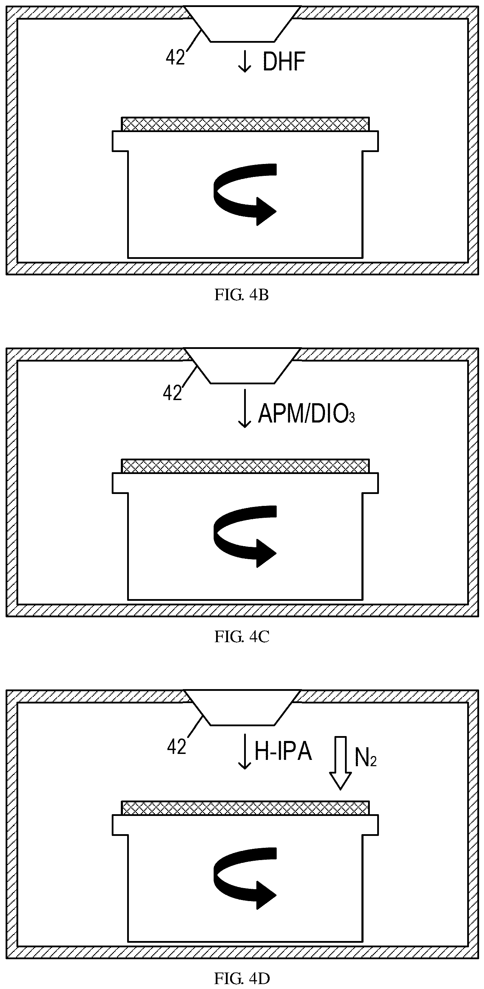

For example, after the trenches are etched, the substrate 20 with the trenches is placed onto the support platform 41 in the processing chamber 40 as shown in FIG. 4A. In the plasma ashing process, a spray head 42 sprays the plasmonized oxygen to the substrate 20 at a flow rate of 13,000 ml/min, and simultaneously sprays the plasmonized mixed gas (the mixed gas is composed of the hydrogen and the nitrogen, and the volume ratio of the hydrogen is 4%) to the substrate at the flow rate of 1,300 ml/min, the temperature in the processing chamber 40 is maintained at 250°C, the pressure is 1,200mtorr, the RF power is 4,400W, and the duration is 21s. After the plasma ashing process is completed, in wet cleaning process, the DHF (1:200) is used as the cleaning agent, as shown in FIG. 4B. The cleaning agent is sprayed onto the surface of the substrate 20 through the spray head 42, meanwhile the support platform 41 rotates at the speed of 1,500 rpm, the temperature is room temperature, and the duration is 130s.

Step S12, forming a transition layer 24, the transition layer 24 at least covering the inner walls of the etched structures 22, where the transition layer 24 is configured to reduce a capillary force exerted by a fluid on the etched structures 22, and to serve as a sacrificial layer configured to repair a collapsed structure, as shown in FIG. 2C.

According to the invention, forming a transition layer 24, the transition layer 24 at least covering the inner walls of the etched structures 22 comprises the following specific step:
oxidizing the semiconductor structure to form an oxide layer, the oxide layer at least covering the inner walls of the trenches, wherein the oxide layer is the transition layer 24.

In some embodiments, oxidizing the semiconductor structure comprises the following specific step:
processing the semiconductor structure by means of an oxidizing liquid, wherein the oxidizing liquid at least fills up the trenches, as shown in FIG. 2B.

The oxidizing liquid is an ozone deionized aqueous solution (DIO₃) or a mixed solution (i.e., APM solution) composed of ammonia water and hydrogen peroxide solution.

In some embodiments, processing the semiconductor structure by means of the oxidizing liquid comprises the following step:
spraying the oxidizing liquid to the surface of the semiconductor structure being spinning to rinse the semiconductor structure.

In some embodiments, the oxide layer has a thickness of 2Å to 12Å.

In some embodiments, after the semiconductor structure is cleaned, as shown in FIG. 4C, the ozone deionized aqueous solution or the APM solution may be sprayed to the substrate 20 through the spray head 42, while the support platform keeps spinning. For example, when the oxidizing liquid is the ozone deionized aqueous solution, the flow rate of O₃ mixed into the deionized water is 1L/min~10L/min, the flow rate of the ozone deionized aqueous solution is 1L/min~10L/min, the process temperature is 5 °C~35 °C, the process duration is 6s~1,800s, the rotation speed of the support platform is 100rpm~1,200rpm, and the thickness of the oxide layer formed is 2Å~12Å. When the oxidizing liquid is the APM solution, the volume ratio of NH₄OH, H₂O₂ and H₂O in the APM solution is NH₄OH:H₂O₂:H₂O=1:(1~10):(10-200)(as an example: NH₄OH:H₂O₂:H₂O=1:7:58), the temperature is 20°C~65°C, the duration is 10 s~600 s, the process conditions such as the flow rate of the APM solution and the rotation speed of the support platform may be the same as those needed when the ozone deionized aqueous solution is used as an oxidizing solution. The oxide layer formed has 2Å~12Å of a thickness. The person skilled in the art may adjust the thickness of the generated transition layer 24 by adjusting the process conditions.

When the material of the substrate 20 is silicon, the material of the transition layer 24 is silicon dioxide. Due to the transition layer 24 formed in the semiconductor structure, the transition layer 24 can be prevented from serving as the interface layer between the silicon and the fluid in the subsequent semiconductor rinsing process, such that the resistance of the trenches to the tension of the fluid can be enhanced, i.e., the capillary force exerted by the fluid on the trenches can be reduced. In this way, the pattern structures such as the trenches may be protected. Additionally, the transition layer 24 (such as the oxide layer) may also change the hydrophobicity of the semiconductor structure, thereby reducing the Van der Waals' force exerted by the silicon surface on the particulates, such that it is more advantageous to removing the particulates inside the etched structures such as the trenches.

Step S13, drying the semiconductor structure, as shown in FIG. 2D.

In some embodiments, drying the semiconductor structure comprises the following specific step:
processing the semiconductor structure by means of isopropanol at a preset temperature to remove the moisture on the surface area of the semiconductor structure.

In some embodiments, as shown in FIG. 4D, hot isopropanol (Hot-IPA) is used as a drying fluid. In one aspect, the Hot-IPA can remove the moisture on the surface area of the semiconductor structure, and in another aspect, it can also help to further reduce the surface tension. The drying fluid is sprayed onto the surface of the semiconductor structure through the spray head 42, and at the same time, the nitrogen is introduced, as the purge gas, into the processing chamber to purge the isopropanol away through the exhaust port of the processing chamber. In this way, the semiconductor structure is dried. The flow rate of the isopropanol is 50ml/min~500ml/min, the temperature is 40°C~80°C, the duration is 10s~600s, and the rotation speed of the support platform is 100 rpm~4,000 rpm. The temperature is preset at 40°C~80°C, for example 60°C.

Step S14, removing the transition layer 24, as shown in FIG. 2F.

In the drying process, due to the effect of the surface energy of the membrane layer on the surface of the wafer, electrostatic friction may be released and/or the attraction between molecules may be applied, and the top of the etched structure is more fragile than the bottom thereof, so the etched structures is prone to tilt at the top due to the aforementioned forces, as shown in the dashed box in FIG. 2D. However, within the elastic limit, after the transition layer 24 is removed, the attraction between the etched structures is broken, and the etched patterns may bounce off thanks to restoring force to restore to its original state, as shown in FIG. 2F.

According to the invention, removing the transition layer 24 comprises the following specific step:
removing the transition layer 24 by means of a mixed gas composed of hydrogen fluoride (99.999% HF gaseous) and ammonia gas as the etching gas.

In some embodiments, the substrate 20 and the transition layer 24 removed by the etching by means of the mixed gas composed of the hydrogen fluoride and the ammonia gas as the etching gas have a total thickness of 1nm to 10nm.

According to the invention, the ratio of the flow of the hydrogen fluoride to the flow of the ammonia gas is (1~2):1.

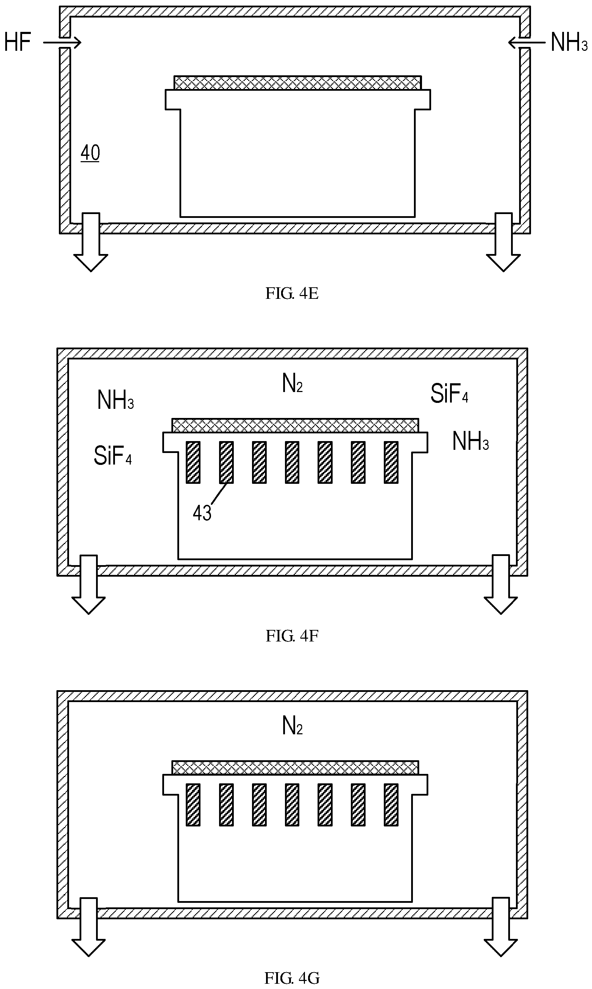

In some embodiments, as shown in FIG. 4E and 4F, HF and NH₃ are simultaneously introduced into the processing chamber, and the transition layer 24 is removed by means of a vapor etching method. Taking as an example where the material of the transition layer 24 is silicon dioxide, the chemical reaction occurring in the process of etching the silicon dioxide by HF and NH₃ is as shown in FIG. 2E. In the process of removing the transition layer, the exhaust gas produced in the reaction process is drawn away in time through the exhaust port at the bottom of the processing chamber, as shown by the arrows in FIG. 4E and FIG. 4F. According to the invention, in the process of etching the transition layer 24, a ratio of the flow of HF to the flow of NH₃ is (1~2):1. The flow rate of HF and the NH₃ is 10 sccm~300 sccm (for example, 25sccm), the temperature is 20°C~150°C (for example, 130°C) , and the duration is 1 s~60 s, the pressure in the processing chamber is 1 mtorr~5,000 mtorr and the temperature of the support platform is 20°C~150°C (for example, 35°C). In this step, the transition layer 24 is over-etched to fully remove the transition layer, such that the etched structures deformed in the drying process by using the isopropanol can be restored to the greatest extent. The thickness of the transition layer 24 etched away may be 1nm to 10 nm. In the process of removing the transition layer 24 in this step, the process of alternately and cyclically introducing NH₃/HF and N₂ may also be adopted. For example, HF and NH₃ are introduced in the first stage, N₂ is introduced in the second stage, HF and NH₃ are introduced in the third stage, N₂ is introduced in the fourth stage..., and so on alternately.

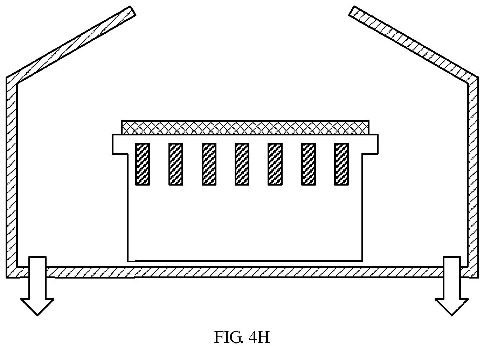

In some embodiments, after removing the transition layer 24, the method further comprises the following step:
purging the semiconductor structure by means of a gas, as shown in FIG. 4G and FIG. 4H.

In some embodiments, after the process of etching the transition layer 24 is completed, in one aspect, a heater 43 inside the support platform is used to heat the substrate 20 to evaporate the products generated in the etching reaction. In another aspect, the nitrogen is introduced into the processing chamber and the processing chamber is continuously evacuated, such that the residues generated after the etching reaction are discharged from the processing chamber in time. Finally, the processing chamber is further purged by means of the nitrogen, as shown in FIG. 4G, until the support platform stops spinning, and the entire wet cleaning process is completed, as shown in FIG. 4H. In the process of gas purging the semiconductor structure by means of the gas, the flow rate of the nitrogen is 200sccm~10,000scem (for example, 2,000sccm). The temperature of the wet cleaning is 90°C~250°C (for example, 95°C), the duration is 20s~600s(for example, 120s), the pressure of the processing chamber is 200 mtorr~10,000 mtorr (for example, 2,000mtorr).

By using the method for processing a semiconductor structure provided in this embodiment, when the depth H of the trench is 300nm or 310nm, the probability of occurrence of collapse or deformation of the pattern after the cleaning process is less than 2%.

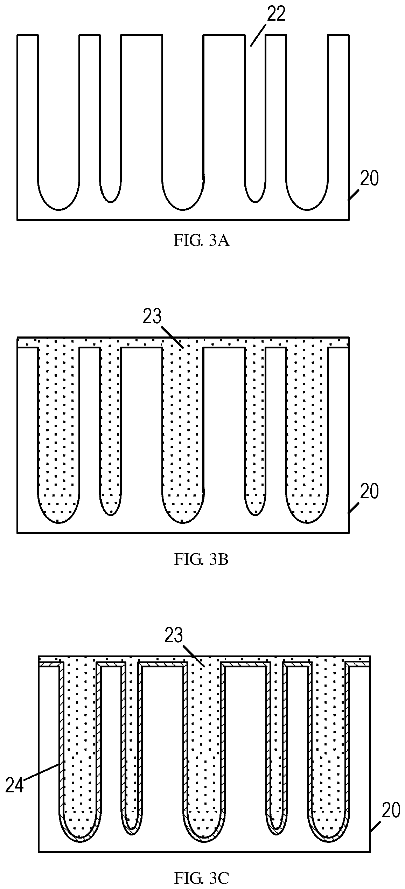

FIGS 2A-2F show a method for processing a semiconductor structure where an etched structures is formed by a mask layer. In other specific embodiments, during processing, the surface of the substrate 20 may also have no mask layer. FIG. 3A-FIG. 3E are schematic diagrams showing major technologies during processing another semiconductor structure according to embodiments of the present disclosure. That is, FIG. 3A-FIG. 3E illustrate schematic diagrams of processing the semiconductor structure having no mask layer on the surface of the substrate. The processing steps and the process conditions during the implementation of each of the processing steps may be the same as the conditions as shown in FIG. 2A to FIG. 2F and FIG. 4A to FIG. 4H.

By using the method for processing a semiconductor structure provided by this embodiment of the present disclosure, the transition layer configured to reduce the capillary force exerted by the fluid on the etched structures is formed on the inner walls of the etched structures, such that the probability of collapse or deformation of the etched structures is reduced in the subsequent process of drying the etched structures. Furthermore, the transition layer covering the inner walls of the etched structures is removed after being dried, and the attraction between the patterns of the etched structures is broken, such that the etched structures deformed in the previous drying process is restored to its original state, thereby further reducing the probability of collapse or deformation of the etched structures. In this way, the performance of the semiconductor structure is improved, and the productivity and the yield of the semiconductor devices are increased.

## Claims

1. A method for processing a semiconductor structure comprising:
providing a semiconductor structure, the semiconductor structure comprising a substrate (20) and a plurality of etched structures (22) arranged on a surface area of the substrate (20) (S11);
forming a transition layer (24), the transition layer (24) at least covering inner walls of the plurality of etched structures (22), the transition layer (24) being configured to reduce a capillary force exerted by a fluid on the etched structures (22) and to serve as a sacrificial layer configured to repair a collapsed structure (S12);
wherein the forming a transition layer (24), the transition layer (24) at least covering inner walls of the plurality of etched structures (22) comprises:
oxidizing the semiconductor structure to form an oxide layer, the oxide layer at least covering inner walls of the trenches, the oxide layer being the transition layer (24);
drying the semiconductor structure (S13); and
removing the transition layer (24), after drying the semiconductor structure (S14);
wherein the removing the transition layer (24) comprises:
removing the transition layer (24) by means of a mixed gas comprising hydrogen fluoride and ammonia gas as etching gas;
wherein flow ratio of the hydrogen fluoride to the ammonia gas is (1~2):1; flow rate of the hydrogen fluoride and the ammonia gas is 10 sccm~300 sccm, temperature is 20°C~150°C, and duration is 1 s~60 s, pressure in a processing chamber is 1 mtorr~5,000 mtorr, and temperature of a support platform is 20°C~150°C.

2. The method for processing a semiconductor structure according to claim 1, wherein the plurality of etched structures (22) are trenches, and number of the trenches arranged on the surface area of the substrate (20) is more than one; and
wherein ratio of depth of each of the trenches to minimum width of the trenches is greater than 8.

3. The method for processing a semiconductor structure according to claim 2, wherein the trenches are arranged in parallel on the surface area of the substrate (20); and
width of pattern line between two adjacent trenches is less than 20 nm.

4. The method for processing a semiconductor structure according to claim 2, wherein the providing a semiconductor structure comprises:
providing the substrate (20);
etching the substrate (20) to form the trenches on the surface area of the substrate (20), bottoms of the trenches extending into the substrate (20) to form the semiconductor structure; and
cleaning the semiconductor structure to remove impurities generated after the trenches are formed by the etching.

5. The method for processing a semiconductor structure according to claim 4, wherein the cleaning the semiconductor structure comprises:
processing the semiconductor structure by means of a plasma ashing process to remove polymer residues generated after the trenches are formed by the etching; and
processing the semiconductor structure by means of a wet cleaning process to remove by-products and pollutants generated after the etching process and the plasma ashing process.

6. The method for processing a semiconductor structure according to claim 5, wherein the processing the semiconductor structure by means of a plasma ashing process comprises:
performing the plasma ashing process on a surface of the semiconductor structure by means of plasmonized oxygen to remove the polymer residues generated after the trenches are formed by the etching.

7. The method for processing a semiconductor structure according to claim 1, wherein the oxidizing the semiconductor structure comprises:
processing the semiconductor structure by means of an oxidizing liquid, the oxidizing liquid at least filling up the trenches, and the oxidizing liquid being an ozone deionized aqueous solution or a mixed solution of ammonia water and hydrogen peroxide.

8. The method for processing a semiconductor structure according to claim 7, wherein the processing the semiconductor structure by means of an oxidizing liquid comprises:
spraying the oxidizing liquid to a surface of the semiconductor structure being spinning to rinse the semiconductor structure.

9. The method for processing a semiconductor structure according to claim 1, wherein the oxide layer has a thickness of 2Å to 12Å.

10. The method for processing a semiconductor structure according to claim 1, wherein a total thickness of the substrate (20) and the transition layer (24) removed by the etching by means of the mixed gas comprising the hydrogen fluoride and the ammonia gas as the etching gas is 1nm to 10nm.

11. The method for processing a semiconductor structure according to claim 2, wherein the drying the semiconductor structure comprises:
processing the semiconductor structure by means of isopropanol at a preset temperature to remove moisture on a surface area of the semiconductor structure.

12. The method for processing a semiconductor structure according to claim 1, after the removing the transition layer (24), the method further comprises:
purging the semiconductor structure by means of a gas.

## Patentansprüche

1. Verfahren zum Verarbeiten einer Halbleiterstruktur,
umfassend:
Bereitstellen einer Halbleiterstruktur, wobei die Halbleiterstruktur ein Substrat (20) und eine Vielzahl von geätzten Strukturen (22) umfasst, die auf einem Oberflächenbereich des Substrats (20) angeordnet sind (S11);
Bilden einer Übergangsschicht (24), wobei die Übergangsschicht (24) zumindest Innenwände der Vielzahl von geätzten Strukturen (22) bedeckt, wobei die Übergangsschicht (24) konfiguriert ist, um eine Kapillarkraft zu reduzieren, die von einem Fluid auf die geätzten Strukturen (22) ausgeübt wird, und um als Opferschicht zu dienen, die konfiguriert ist, um eine kollabierte Struktur zu reparieren (S12);
wobei das Bilden einer Übergangsschicht (24), wobei die Übergangsschicht (24) zumindest Innenwände der Vielzahl von geätzten Strukturen (22) bedeckt, Folgendes umfasst:
Oxidieren der Halbleiterstruktur, um eine Oxidschicht zu bilden, wobei die Oxidschicht zumindest Innenwände der Gräben bedeckt und die Oxidschicht die Übergangsschicht (24) ist;
Trocknen der Halbleiterstruktur (S13); und
Entfernen der Übergangsschicht (24) nach Trocknen der Halbleiterstruktur (S14);
wobei das Entfernen der Übergangsschicht (24) Folgendes umfasst:
Entfernen der Übergangsschicht (24) mittels eines Mischgases, umfassend Fluorwasserstoff und Ammoniakgas als Ätzgas;
wobei ein Durchflussverhältnis des Fluorwasserstoffs zu dem Ammoniakgas (1~2):1 ist; eine Durchflussrate des Fluorwasserstoffs und des Ammoniakgases 10 sccm-300 sccm ist, eine Temperatur 20 °C~150 °C ist und eine Dauer 1 Sek-60 Sek ist, ein Druck in einer Prozesskammer 1 mtorr-5000 mtorr ist und eine Temperatur einer Trägerplattform 20 °C~150 °C ist.

2. Verfahren zum Verarbeiten einer Halbleiterstruktur nach Anspruch 1, wobei die Vielzahl von geätzten Strukturen (22) Gräben sind und eine Anzahl der auf der Oberfläche des Substrats (20) angeordneten Gräben mehr als eins ist; und
wobei ein Tiefenverhältnis von jedem der Gräben zu der Mindestbreite der Gräben größer ist als 8.

3. Verfahren zur Verarbeiten einer Halbleiterstruktur nach Anspruch 2, wobei die Gräben parallel auf der Oberfläche des Substrats (20) angeordnet sind; und
eine Breite der strukturierten Leitung zwischen zwei benachbarten Gräben weniger als 20 nm ist.

4. Verfahren zum Verarbeiten einer Halbleiterstruktur nach Anspruch 2, wobei das Bereitstellen einer Halbleiterstruktur Folgendes umfasst:
Bereitstellen des Substrats (20);
Ätzen des Substrats (20), um die Gräben auf der Oberfläche des Substrats (20) zu bilden, wobei sich Böden der Gräben in das Substrat (20) erstrecken, um die Halbleiterstruktur zu bilden; und
Reinigen der Halbleiterstruktur, um Verunreinigungen zu entfernen, die nach Bilden der Gräben durch das Ätzen gebildet werden.

5. Verfahren zum Verarbeiten einer Halbleiterstruktur nach Anspruch 4, wobei das Reinigen der ersten Halbleiterstruktur Folgendes umfasst:
Verarbeiten der Halbleiterstruktur mittels eines Plasmaveraschungsprozesses, um Polymerrückstände zu entfernen, die nach Bilden der Gräben durch das Ätzen gebildet werden; und
Verarbeiten der Halbleiterstruktur mittels eines Nassreinigungsverfahrens zum Entfernen von Nebenprodukten und Verunreinigungen, die nach dem Ätzprozess und dem Plasmaveraschungsprozess erzeugt werden.

6. Verfahren zum Verarbeiten einer Halbleiterstruktur nach Anspruch 5, wobei das Verarbeiten der Halbleiterstruktur mittels eines Plasmaveraschungsprozesses Folgendes umfasst:
Durchführen des Plasmaveraschungsprozesses auf einer Oberfläche der Halbleiterstruktur mittels plasmonisiertem Sauerstoff, um die Polymerrückstände zu entfernen, die nach Bilden der Gräben durch das Ätzen gebildet werden.

7. Verfahren zum Verarbeiten einer Halbleiterstruktur nach Anspruch 1, wobei das Oxidieren der ersten Halbleiterstruktur Folgendes umfasst:
Verarbeiten der Halbleiterstruktur mittels einer oxidierenden Flüssigkeit, wobei die oxidierende Flüssigkeit zumindest die Gräben auffüllt und die oxidierende Flüssigkeit eine mit Ozon entionisierte wässrige Lösung oder eine gemischte Lösung aus Ammoniakwasser und Wasserstoffperoxid ist.

8. Verfahren zum Verarbeiten einer Halbleiterstruktur nach Anspruch 7, wobei das Verarbeiten der Halbleiterstruktur mittels einer oxidierenden Flüssigkeit Folgendes umfasst:
Sprühen der oxidierenden Flüssigkeit auf eine Oberfläche, die geschleudert wird, um die Halbleiterstruktur zu spülen.

9. Verfahren zum Verarbeiten einer Halbleiterstruktur nach Anspruch 1, wobei die Oxidschicht eine Stärke von 2Å bis 12Å aufweist.

10. Verfahren zum Verarbeiten einer Halbleiterstruktur nach Anspruch 1, wobei eine Gesamtstärke des Substrats (20) und der Übergangsschicht (24), die durch das Ätzen mittels des Mischgases, das den Fluorwasserstoff und das Ammoniakgas als Ätzgas umfasst, entfernt wird, 1 nm bis 10 nm ist.

11. Verfahren zum Verarbeiten einer Halbleiterstruktur nach Anspruch 2, wobei das Trocknen der ersten Halbleiterstruktur Folgendes umfasst:
Verarbeiten der Halbleiterstruktur mittels Isopropanol bei einer vorgegebenen Temperatur, um Feuchtigkeit auf einer Oberfläche der Halbleiterstruktur zu entfernen.

12. Verfahren zum Verarbeiten einer Halbleiterstruktur nach Anspruch 1, wobei das Verfahren nach dem Entfernen der Übergangsschicht (24) ferner Folgendes umfasst:
Spülen der Halbleiterstruktur mittels eines Gases.

## Revendications

1. Procédé de traitement d'une structure semi-conductrice
comprenant :
la fourniture d'une structure semi-conductrice, la structure semi-conductrice comprenant un substrat (20) et une pluralité de structures gravées (22) disposées sur une surface du substrat (20) (S11) ;
la formation d'une couche de transition (24), la couche de transition (24) recouvrant au moins les parois internes de la pluralité de structures gravées (22), la couche de transition (24) étant configurée pour réduire une force capillaire exercée par un fluide sur les structures gravées (22) et pour servir de couche sacrificielle configurée pour réparer une structure effondrée (S12) ;
dans lequel la formation d'une couche de transition (24), la couche de transition (24) couvrant au moins les parois internes de la pluralité de structures gravées (22), comprend :
l'oxydation de la structure semi-conductrice pour former une couche d'oxyde, la couche d'oxyde recouvrant au moins les parois internes des tranchées, la couche d'oxyde étant la couche de transition (24) ;
le séchage de la structure semi-conductrice (S13) ; et
le retrait de la couche de transition (24) après avoir séché la structure semi-conductrice (S14) ;
dans lequel l'élimination de la couche de transition (24) comprend :
l'élimination de la couche de transition (24) au moyen d'un gaz mixte comprenant du fluorure d'hydrogène et de l'ammoniac comme gaz de gravure ;
dans lequel le rapport de débit entre le fluorure d'hydrogène et le gaz ammoniac est de (1~2) : 1 ; le débit du fluorure d'hydrogène et du gaz ammoniac est de 10 sccm~300 sccm, la température est de 20 °C~150 °C, et la durée est de 1 s~60 s, la pression dans une chambre de traitement est de 1 mtorr~5 000 mtorr, et la température d'une plate-forme de support est de 20 °C~150 °C.

2. Procédé de traitement d'une structure semi-conductrice selon la revendication 1, dans lequel la pluralité de structures gravées (22) sont des tranchées, et le nombre de tranchées disposées sur la surface du substrat (20) est supérieur à un ; et
dans lequel le rapport entre la profondeur de chacune des tranchées et la largeur minimale des tranchées est supérieur à 8.

3. Procédé de traitement d'une structure semi-conductrice selon la revendication 2, dans lequel les tranchées sont disposées en parallèle sur la surface du substrat (20) ; et
la largeur de la ligne de motif entre deux tranchées adjacentes est inférieure à 20 nm.

4. Procédé de traitement d'une structure semi-conductrice selon la revendication 2, dans lequel la fourniture d'une structure semi-conductrice comprend :
la fourniture du substrat (20) ;
la gravure du substrat (20) pour former les tranchées sur la surface du substrat (20), les fonds des tranchées s'étendant dans le substrat (20) pour former la structure semi-conductrice ; et
le nettoyage de la structure semi-conductrice pour éliminer les impuretés générées après la formation des tranchées par la gravure.

5. Procédé de traitement d'une structure semi-conductrice selon la revendication 4, dans lequel le nettoyage de la structure semi-conductrice comprend :
le traitement de la structure semi-conductrice au moyen d'un procédé de décapage au plasma afin d'éliminer les résidus de polymère générés après la formation des tranchées par la gravure ; et
le traitement de la structure semi-conductrice au moyen d'un processus de nettoyage humide pour éliminer les sous-produits et les polluants générés après le processus de gravure et le processus d'incinération au plasma.

6. Procédé de traitement d'une structure semi-conductrice selon la revendication 5, dans lequel le traitement de la structure semi-conductrice au moyen d'un procédé d'incinération au plasma comprend :
la réalisation du processus de décapage au plasma sur une surface de la structure semi-conductrice au moyen d'oxygène plasmonisé afin d'éliminer les résidus de polymère générés après la formation des tranchées par la gravure.

7. Procédé de traitement d'une structure semi-conductrice selon la revendication 1, dans lequel l'oxydation de la structure semi-conductrice comprend :
le traitement de la structure semi-conductrice au moyen d'un liquide oxydant, le liquide oxydant remplissant au moins les tranchées, et le liquide oxydant étant une solution aqueuse désionisée d'ozone ou une solution mixte d'eau ammoniaquée et de peroxyde d'hydrogène.

8. Procédé de traitement d'une structure semi-conductrice selon la revendication 7, dans lequel le traitement de la structure semi-conductrice au moyen d'un liquide oxydant comprend :
la pulvérisation du liquide oxydant sur une surface de la structure semi-conductrice en cours d'essorage pour rincer la structure semi-conductrice.

9. Procédé de traitement d'une structure semi-conductrice selon la revendication 1, dans lequel la couche d'oxyde présente une épaisseur de 2Å à 12Å.

10. Procédé de traitement d'une structure semi-conductrice selon la revendication 1, dans lequel l'épaisseur totale du substrat (20) et de la couche de transition (24) enlevée par la gravure au moyen du gaz mixte comprenant le fluorure d'hydrogène et le gaz ammoniac comme gaz de gravure est comprise entre 1 nm et 10 nm.

11. Procédé de traitement d'une structure semi-conductrice selon la revendication 2, dans lequel le séchage de la structure semi-conductrice comprend :
le traitement de la structure semi-conductrice au moyen d'isopropanol à une température prédéfinie afin d'éliminer l'humidité sur une surface de la structure semi-conductrice.

12. Procédé de traitement d'une structure semi-conductrice selon la revendication 1, après avoir enlevé la couche de transition (24), le procédé comprend en outre : la purge de la structure semi-conductrice au moyen d'un gaz.
